Europäisches Patentamt

European Patent Office

Office européen des brevets

(19)

(11) **EP 0 966 557 B1**

(12) **EUROPÄISCHE PATENTSCHRIFT**

(45) Veröffentlichungstag und Bekanntmachung des Hinweises auf die Patenterteilung:
**02.05.2002   Patentblatt 2002/18**

(21) Anmeldenummer: **98910610.9**

(22) Anmeldetag: **02.02.1998**

(51) Int Cl.⁷: $C25F\ 7/00$, $C25D\ 5/18$

(86) Internationale Anmeldenummer:
**PCT/DE98/00383**

(87) Internationale Veröffentlichungsnummer:
**WO 98/38357 (03.09.1998 Gazette 1998/35)**

(54) **SCHALTUNGSANORDNUNG UND VERFAHREN ZUR PULSSTROMVERSORGUNG VON GALVANISIER- ODER ÄTZANLAGEN**

CIRCUITRY AND METHOD FOR AN ELECTROPLATING PLANT OR ETCHING PLANT PULSE POWER SUPPLY

MONTAGE ET PROCEDE D'ALIMENTATION EN COURANT IMPULSIONNEL D'INSTALLATION DE GALVANOPLASTIE OU DE DECAPAGE

(84) Benannte Vertragsstaaten:
**AT CH DE ES FI FR GB IT LI NL SE**

(30) Priorität: **27.02.1997   DE 19707905**

(43) Veröffentlichungstag der Anmeldung:
**29.12.1999   Patentblatt 1999/52**

(73) Patentinhaber: **ATOTECH DEUTSCHLAND GMBH 10553 Berlin (DE)**

(72) Erfinder: **MAURER, Manfred D-91180 Heideck (DE)**

(74) Vertreter: **Effert, Bressel und Kollegen Radickestrasse 48 12489 Berlin (DE)**

(56) Entgegenhaltungen:
**WO-A-89/07162          DE-A- 3 609 296**

**Beschreibung**

Die Erfindung betrifft eine Schaltungsanordnung und ein Verfahren zur Versorgung einer oder mehrerer parallel geschalteter elektrolytischer Zellen mit pulsförmigem Strom. Das Verfahren wird vorzugsweise zum Galvanisieren von Leiterplatten in vertikalen Tauchbadanlagen sowie in vertikalen und horizontalen Durchlaufanlagen angewendet.

Das Pulsstromgalvanisieren erlaubt die Beeinflussung von bestimmten Eigenschaften der abgeschiedenen metallischen Schichten. So lassen sich die physikalischen Eigenschaften der Galvanisierschichten in weiten Grenzen verändern. Insbesondere die Streuung wird verbessert. Ferner läßt sich die Oberflächenbeschaffenheit beeinflussen. Besonders vorteilhaft ist auch, daß die resultierende Galvanisierstromdichte und die Produktqualität deutlich erhöht werden können. Den Vorteilen, bezogen auf das zu galvanisierende Produkt, steht der gerätetechnische Aufwand zur Erzeugung des Pulsstromes als Nachteil gegenüber. Die zur Pulsstromversorgung verwendeten Anlagen stoßen schnell an physikalische, technische und wirtschaftliche Grenzen, wenn mit zeitlich kurzen Strompulsen galvanisiert werden soll. Unter zeitlich kurz werden hier Pulszeiten im Bereich von $0{,}1 \cdot 10^{-3}$ bis $10 \cdot 10^{-3}$ Sekunden verstanden. Gerade in diesem Zeitbereich ist das Galvanisieren mit Pulsstrom besonders wirkungsvoll. Bei Anwendung von bipolaren Pulsen wird das Behandlungsgut abwechselnd kathodisch und anodisch gepolt. Soll das Behandlungsgut galvanisiert werden, muß das kathodische Strom-Zeit-Produkt (kathodische Ladung) größer sein als das anodische Strom-Zeit-Produkt (anodische Ladung).

Die Vorteile der Pulsgalvanisierung können auch bei der elektrolytischen Behandlung von Leiterplatten genutzt werden. Zur Herstellung von Leiterplatten werden vertikale und horizontale Galvanisieranlagen eingesetzt. Derartige Anlagen weisen in der Regel große räumliche Abmessungen auf. Ferner sind die Galvanisierströme in diesem Fall groß. Daher müssen Galvanogleichrichter mit entsprechend großer Leistung an der Galvanisieranlage installiert werden.

Die fast immer bestehenden beschränkten Platzverhältnisse erlauben oft nicht, daß die Galvanogleichrichter mit Pulsgeneratoren sehr nahe an den Galvanisierbädern aufgestellt werden können. Dies steht im Gegensatz zu den Anforderungen bei Anwendung der Puistechnik: Bei bekannten Verfahren und Anlagen muß die Entfernung vom Galvanogleichrichter zum Bad, das heißt zur elektrolytischen Zelle, zum Erreichen der geforderten Flankensteilheit der Pulsströme sehr kurz sein. Bei den üblicherweise großen Pulsströmen $I_p$ und im Falle niedriger Badwiderstände $R_{Bad}$ muß die Induktivität $L_L$ der Stromleiter vom Galvanogleichrichter zur elektrolytischen Zelle klein gehalten werden. Praktisch ist dies nur mit sehr kurzen Leitungen realisierbar. Weitere Maßnahmen zur Verringerung der Leiterinduktivität sind bekannt, wie zum Beispiel das Verdrillen von Hin- und Rückleiter. Diese Stromleiterführung ist zwar bei Kabeln mit kleinem Leiterquerschnitt möglich. Bei den üblichen Stromschienen für die hohen Galvanisierströme ist eine Verdrillung dagegen unmöglich. Die Zeitkonstante Tau für den Stromanstieg am Badwiderstand $R_{Bad}$ wird nach der Formel

$$Tau = L_L/R_{Bad}$$

berechnet. Beträgt die Entfernung vom Galvanogleichrichter mit Pulsgenerator zum Bad zum Beispiel nur drei Meter, so sind dies bei einer Leiterinduktivität von zum Beispiel $1 \cdot 10^{-6}$ Henry pro Meter für den Hin- und den Rückleiter $6 \cdot 10^{-6}$ Henry.

Wird für den Badwiderstand ein Wert von $R_{Bad} = 3 \cdot 10^{-3}$ Ohm angenommen, so ergibt dies bei einer zulässigen Vernachlässigung des ohmschen Leiterwiderstandes eine Zeitkonstante von

$$Tau = L_L/R_{Bad} = (6 \cdot 10^{-6} \text{ Henry}) / (3 \cdot 10^{-3} \text{ Ohm}) = 2 \cdot 10^{-3} \text{ Sekunden.}$$

Bei idealem Spannungsanstieg am Pulsgenerator steigt somit der Strom am Badwiderstand $R_{Bad}$ in $2 \cdot 10^{-3}$ Sekunden auf 63 Prozent des Maximalstromes an. Diese Pulsanstiegsgeschwindigkeit ist zum Beispiel bei der Leiterplattengalvanisierung unzureichend. In diesem Fall wird mit den obengenannten Pulslängen gearbeitet. Entsprechend kürzer muß die Pulsanstiegszeit sein.

Eine horizontale Galvanisieranlage für Leiterplatten besteht zum Beispiel aus 25 parallelgeschalteten Anoden an der Leiterplattenunterseite und 25 parallelgeschalteten Anoden an der Leiterplattenoberseite. Die Pulsströme betragen auf jeder Seite bis zu 15.000 Ampere. Die Abmessungen einer derartigen Galvanisieranlage betragen in Transportrichtung zum Beispiel sechs Meter. Entsprechend lang müssen die Stromleiter vom Galvanogleichrichter mit Pulsgenerator zu den Anoden sein.

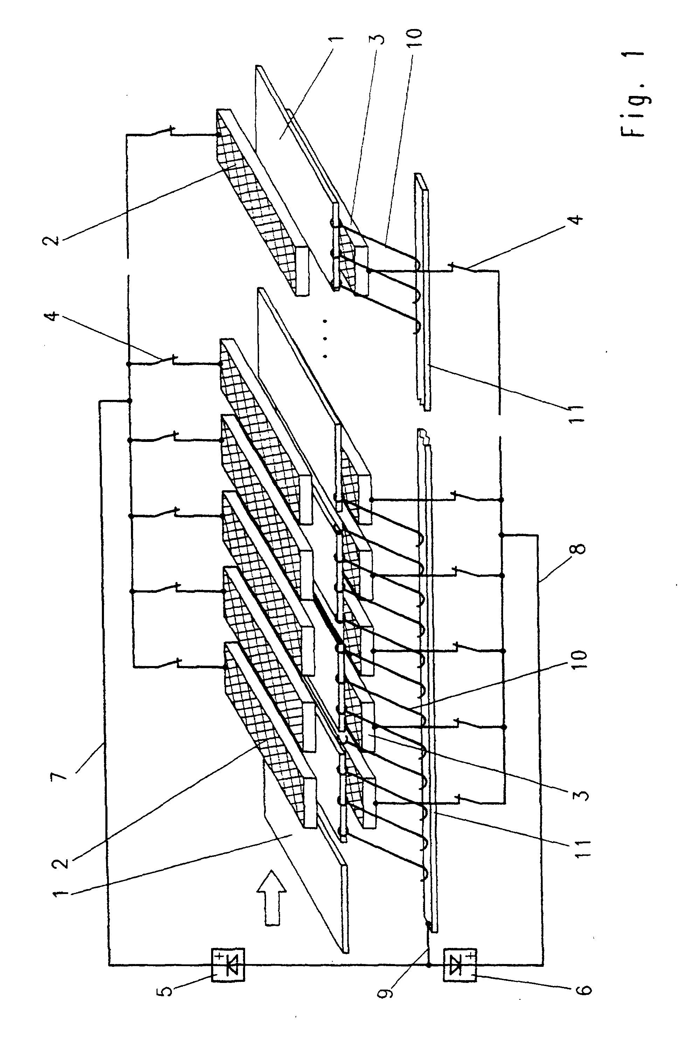

Eine übliche Anlage ist in Figur 1 schematisch dargestellt:

Die zu behandelnden Leiterplatten 1 werden zwischen den oberen Anoden 2 und den unteren Anoden 3 von nicht dargestellten Antriebselementen in Pfeilrichtung durch die Anlage hindurchtransportiert. Bei den Anoden kann es sich sowohl um lösliche als auch um unlösliche Anoden handeln. In einer derartigen Durchlaufanlage bildet jede Anode mit der zugehörigen Kathode (Leiterplatte) und dem Elektrolyten eine elektrolytische Teilzelle. Vorzugsweise bilden alle oberen Anoden 2 bilden zusammen mit der Oberseite des Behandlungsgutes und dem Elektrolyten die obere elektrolytische Gesamtzelle, die vom Galvanogleichrichter 5 mit Badstrom versorgt wird. Entsprechend bilden die unteren Anoden 3 zusammen mit der Unterseite des Behandlungsgutes und dem Elektrolyten die untere elektrolytische Gesamtzelle. Die Anoden 2, 3 sind über je einen Schaltkontakt 4 mit einem gemeinsamen oberen Galvanogleichrichter 5 und einem gemeinsamen unteren Galvanogleichrichter 6 elektrisch leitend verbunden. Der Abstand der Galvanogleichrichter 5, 6 von der Galvanoanlage beträgt wegen der großen Abmessungen des Gleichrichters in der Praxis mindestens einige Meter. Entsprechend lang sind der Stromleiter 7 zu den oberen Anoden und der Stromleiter 8 zu den unteren Anoden. Der gemeinsame Stromrückleiter 9 schließt die Stromkreise der Galvanogleichrichter. Das Behandlungsgut wird mittels elektrischer Kontaktelemente, zum Beispiel in Form von Klammern 10, die gleitend und elektrisch leitend mit einer Schleifschiene 11 in Verbindung stehen, an Leitung 9 angeschlossen. Die Schaltkontakte 4, in der Regel elektromechanische Schützkontakte, dienen zum individuellen Zuschalten der Anoden beim Einfahren der ersten Leiterplatten in die Durchlaufanlage und zum individuellen Abschalten der Anoden beim Ausfahren der letzten Leiterplatten aus der Durchlaufanlage beziehungsweise beim Auftreten von Lücken zwischen den Leiterplatten. Die Funktion der Schaltkontakte 4 ist in DE-A-39 39 681 beschrieben. Auf diese Schrift wird verwiesen.

Bei herkömmlicher Technik verursachen die erforderlichen hohen Stromanstiegsgeschwindigkeiten in Verbindung mit den hohen Strömen in den Stromleitern vom Pulsgenerator zum Bad starke magnetische Störfelder. Die für die Arbeit im Umfeld derartiger Störfelder zulässigen Feldstärken sind in entsprechenden Normen festgelegt. Auch Sicherheitsvorschriften zum Schutz des Bedienungspersonals der Galvanisieranlagen, wie sie zum Beispiel in der deutschen Norm VDE 0848 beschrieben sind, müssen eingehalten werden. Daher sind technisch aufwendige Abschirmmaßnahmen mit entsprechend hohen Kosten erforderlich. Bei sehr hohen Galvanisierströmen scheitern auch diese Maßnahmen.

Die beschriebenen technischen und wirtschaftlichen Probleme beim Galvanisieren mit schnellen Pulsen stellen Gründe dafür dar, daß sich ein großtechnischer Einsatz der Pulstechnik bisher nicht durchgesetzt hat.

In WO 89/07162 A1 wird ein elektrochemischer Prozeß unter Anwendung eines Pulsverfahrens beschrieben. Beim Reverspulsverfahren werden mindestens eine Badspannungsquelle in Vorwärtsrichtung, das heißt galvanisierend, und mindestens eine weitere Badspannungsquelle in Rückwärtsrichtung, das heißt ätzend bzw. entmetallisierend, abwechselnd an das elektrolytische Bad geschaltet. Die einstellbaren Spannungsquellen treiben den Badstrom. Die Amplitude und das Zeitverhalten des Stromes sind bei Spannungsquellen abhängig von den ohmschen und induktiven Widerständen des Badstromkreises. Die Spannungsumschaltung und damit zugleich das Erzeugen der Strompulse in Vorwärts- und Rückwärtsrichtung wird mit Solid-State-Switches realisiert, die in der Lage sind, die erforderliche hohe Pulsfrequenz von bis zu 5000 Hertz zu schalten. Beim Galvanisieren muß der Badstrommittelwert in Vorwärtsrichtung, das heißt bei kathodischer Polung des Galvanisiergutes, deutlich größer sein als der Badstrommittelwert in Rückwärtsrichtung, das heißt bei anodischer Polung. Die vorgeschlagenen Schalter zur Erzeugung von bipolaren Strompulsen aus zwei Spannungsquellen sind für zeitlich kurze Pulse in realen Galvanoanlagen ungeeignet. Die Stromleiter von den Spannungsquellen zu den großräumigen Anlagen sind so lang, daß infolge der entsprechend hohen Leiterinduktivität die Pulsanstiegsgeschwindigkeiten wesentlich größer sind als die erforderliche Pulslänge, insbesondere die Reverspulslänge. Dies gilt unabhängig davon, an welcher Stelle des Galvanisierstromkreises die Solid-State-Switches in den Galvanisierstromkreis eingefügt sind, das heißt in Serie geschaltet werden.

Bekannt ist auch, daß beim Abschalten eines Stromes einer induktiven Last eine Induktionsspannung mit einer Amplitude entsteht, die von der Abschaltgeschwindigkeit und von der Größe der Induktivität abhängt. Diese Spannung addiert sich zur stromtreibenden Spannung. Die Summe der Spannungen steht am geöffneten Schalter an. Dieser wird ohne aufwendige Schutzmaßnahmen zerstört, insbesondere bei den in Galvanoanlagen üblichen hohen Energien, die geschaltet werden.

Bekannte Löschbeschaltungen parallel zur Induktivität sind bei den großräumigen Galvanisieranlagen nicht realisierbar. Eine Löschbeschaltung hätte des weiteren den Nachteil, daß das Abklingen des Stromes beim Ausschalten wesentlich langsamer werden würde. Als weiterer Nachteil der vorgeschlagenen Schalter erweist sich die Notwendigkeit, sehr aufwendige Schutzmaßnahmen gegen die starken magnetischen Felder im Bereich der Stromleiter zu installieren.

Die nicht zu vermeidende Leiterinduktivität im Badstromkreis wirkt sich immer nachteilig auf die Pulsgenerierung aus. Auch versuchsweise konnten mit dieser Technik Pulsanstiegszeiten mit Tau kleiner als $2 \cdot 10^{-3}$ Sekunden nicht erreicht werden. Der Aufwand zum Schutz der elektronischen Schalter sowie zum Schutz des Personals gegen die starken magnetischen Felder war in diesem Fall unverhältnismäßig groß.

Der vorliegenden Erfindung liegt von daher das Problem zugrunde, die Nachteile der bekannten Verfahren und Schaltungsanordnungen zu vermeiden und insbesondere ein Verfahren und eine Schaltungsanordnung zur Pulsstromversorgung von elektrolytischen Zellen anzugeben, mit dem in großen Galvanisier- und Ätzanlagen mit einer oder mehreren elektrolytischen Zellen Pulsströme mit großer Flankensteilheit erzeugt werden können und mit dem zugleich die Erzeugung von elektromagnetischen Feldern auf ein Minimum begrenzt wird.

Das Problem wird gelöst durch die Schaltungsanordnung nach Anspruch 1 und die Verfahren nach den Ansprüchen 9 und 10. Bevorzugte Ausführungsformen der Erfindung sind in den Unteransprüchen angegeben.

In der erfindungsgemäßen Schaltungsanordnung für eine Versorgung einer oder mehrerer parallel geschalteter elektrolytischer Zellen, die Anoden und Kathoden aufweisen, mit pulsförmigem Strom, sind jeder einzelnen elektrolytischen Zelle

a. mindestens ein Galvanogleichrichter und

b. mindestens ein Umschalter, der von mindestens zwei Eingängen auf mindestens einen Ausgang durchschaltbar ist, oder ein Ein/Ausschalter zugeordnet,

c. wobei erste Leitungen zur direkten elektrischen Verbindung jeweils eines Anschlusses der Gleichrichter mit dem einen Anschluß der elektrolytischen Zelle und

d. zweite Leitungen zur direkten elektrischen Verbindung der jeweils anderen Ausgänge der Gleichrichter mit den Eingängen der Umschalter oder eines Anschlusses des Ein/Ausschalters vorgesehen sind,

e. wobei ferner der Ausgang oder die Ausgänge des mindestens einen Umschalters oder der andere Anschluß des Ein/Ausschalters mit dem anderen Anschluß der elektrolytischen Zelle direkt verbunden sind und

f. zwischen die erste Leitung und jede zweite Leitung mindestens ein Kondensator geschaltet ist.

Mit entsprechender Ansteuerung der Umschalter zum periodischen Schließen und Öffnen der Verbindungen von den Gleichrichtern über die zweiten Leitungen zur elektrolytischen Zelle werden mit dieser Schaltungsanordnung beim Galvanisieren oder Ätzen, insbesondere Entmetallisieren, folgende Verfahrensschritte durchgeführt:

A. In einem ersten Zeitintervall $t_1$ (beispielsweise zum Erzeugen eines kathodischen Strompulses am Behandlungsgut: $t_k$):

a. Die elektrolytische Zelle wird durch Verbinden eines ersten Gleichrichters mit der Zelle über eine zweite Leitung und mindestens einen Umschalter gespeist und

b. gleichzeitig der oder die Kondensatoren partiell entladen, die über eine der zweiten Leitungen mit dem ersten Gleichrichter verbunden sind.

c. Die Kondensatoren, die über die anderen der zweiten Leitungen mit den anderen Gleichrichtern verbunden sind, werden geladen.

B. In einem zweiten Zeitintervall $t_2$ (beispielsweise zum Erzeugen eines anodischen Strompulses am Behandlungsgut: $t_a$):

d. Die elektrolytische Zelle wird durch Verbinden eines zweiten Gleichrichters mit der Zelle über eine zweite Leitung und mindestens einen Umschalter gespeist und

e. gleichzeitig der oder die Kondensatoren partiell entladen, die über eine der zweiten Leitungen mit dem zweiten Gleichrichter verbunden sind.

f. Die Kondensatoren, die über die übrigen der zweiten Leitungen mit den übrigen Gleichrichtern verbunden sind, werden geladen.

Um zu vermeiden, daß die Schalter oder andere Komponenten zerstört werden, sollen nicht gleichzeitig mehrere Gleichrichter mit der elektrolytischen Zelle über die Schalter verbunden sein. Daher wird das als "break before make" bekannte Verfahren angewandt, wonach die Verbindung zwischen der elektrolytischen Zelle und einem Gleichrichter durch einen Schalter getrennt wird, bevor eine neue Verbindung zwischen der Zelle und einem anderen Gleichrichter hergestellt wird. Dadurch können die Galvanogleichrichter nicht gegeneinander kurzgeschlossen werden.

Bei Verwendung von Ein/Ausschaltern werden folgende Verfahrensschritte durchgeführt:

A. In einem ersten Zeitintervall $t_1$ (beispielsweise zum Erzeugen eines kathodischen Strompulses am Behandlungsgut: $t_k$):

a. Die elektrolytische Zelle wird durch Verbinden des oder der Gleichrichter mit der Zelle über die zweite Leitung und den Ein/Ausschalter gespeist

b. und die Kondensatoren gleichzeitig partiell entladen.

B. In einem zweiten Zeitintervall $t_2$ (beispielsweise zum Erzeugen eines anodischen Strompulses am Behandlungsgut: $t_a$):

c. Die Verbindung zwischen der elektrolytischen Zelle und dem oder den Gleichrichtern wird durch den Ein/Ausschalter unterbrochen, und

d. die Kondensatoren werden geladen.

Durch ständige Wiederholung dieser Verfahrensschritte a-b-c-d-e-f bzw. a-b-c-d wird eine periodische Strompulsfolge in der elektrolytischen Zelle erzeugt. Bipolarer, pulsförmiger Strom zeichnet sich durch eine Folge von positiven und negativen Strompulsen aus. Für bestimmte Anwendungen können aber auch unipolare Strompulsfolgen mit ausschließlich kathodischen oder ausschließlich anodischen Strompulsen erzeugt werden, die beispielsweise jeweils unterschiedliche Stromscheitelwerte aufweisen.

Als elektrolytische Zelle ist eine Anordnung, die durch mindestens eine Kathode und eine Anode sowie die sich zwischen diesen beiden Elektroden befindende Elektrolytflüssigkeit gebildet ist, anzusehen. Zusammen mit den jeweiligen Elektrolyten sind damit bei der Leiterplattenherstellung zum einen eine Leiterplattenseite und die dieser gegenüberliegende Anode als eine elektrolytische Zelle und zum anderen die andere Leiterplattenseite und die dieser gegenüberliegende andere Anode als eine andere elektrolytische Zelle zu betrachten.

Vorzugsweise sind sowohl die Um- und Aus/Einschalter als auch die Kondensatoren in Bezug zur elektrolytischen Zelle so angeordnet, daß die Induktivität der die elektrolytische Zelle und die Schalter verbindenden Stromleiter minimiert wird. Beispielsweise werden die Schalter und die Kondensatoren in räumlicher Nähe zur elektrolytischen Zelle angeordnet, indem dieser Stromleiter möglichst kurz gehalten wird. Außerdem können übliche Methoden zur Optimierung der Leitungsführung ausgenutzt werden, um die Leiterinduktivitäten zu minimieren.

In einer bevorzugten Ausführungsform sind zwei Gleichrichter vorgesehen, mit denen mehrere parallelgeschaltete elektrolytische Zellen gemeinsam mit Strom versorgt werden können, wobei jeweils mehrere Stromkreise gemeinsame Kondensatoren zur Versorgung der eiektrolytischen Zellen aufweisen. Diese Stromkreise sind vorzugsweise jeweils einem Gleichrichter zugeordnet. Dies bedeutet, daß eine Gruppe von mehreren elektrolytischen Zellen über den Umschalter mit nur einem Kondensator verbunden sind und dieser Kondensator wiederum mit einem Gleichrichter. Eine andere Gruppe von elektrolytischen Zellen ist über den Umschalter oder Ein/Ausschalter mit einem anderen Kondensator verbunden und dieser mit einem anderen Gleichrichter.

Als eine Gruppe von elektrolytische Zellen, die einem Kondensator zugeordnet ist, kann die Gruppe der auf einer Seite von auf einer Transportbahn bewegten Leiterplatten angeordneten elektrolytischen Zellen, bestehend aus den dieser Seite zugewandten Leiterplattenoberflächen, den auf dieser Seite angeordneten Anoden und der sich zwischen diesen Elektroden befindenden Elektrolytlösung, geschaltet sein. Die andere Gruppe von elektrolytischen Zellen, die einem anderen Kondensator zugeordnet ist, wird durch die aus den auf der anderen Seite der Transportbahn befindliche Gruppe von elektrolytischen Zellen gebildet.

Um eine wartungsarme Schaltungsanordnung und hohe Pulsfrequenzen, beispielsweise von bis zu 1000 Hertz, zu erreichen, können zur Erzeugung der Pulsfolge elektronische Schalter vorgesehen sein. Prinzipiell möglich sind auch mechanische Schalter. In diesem Fall können Drehschalter und Wechselschalter für die Schalter eingesetzt werden sowie Schaltungen mit mehreren Einzelschaltern, die parallel zueinander geschaltet und wechselweise betätigt werden.

Zur exakten Regelung der Stromhöhen in den elektrolytischen Zellen können die Um- bzw. Aus/Einschalter jeweils mit einem Stromsensor ausgestattet sein. Die mit diesen Sensoren ermittelbaren Meßsignale werden auch zur Überstromausschaltung zum Schutz der Schalter ausgewertet.

Die erfindungsgemäße Schaltungsanordnung kann ferner derart in eine Galvanisier- oder Ätzanlage integriert werden, daß die Meßsignale jedes Stromsensors an eine in der Anlage enthaltene, übergeordnete Steuerung übertragen werden können, die zur Überwachung und Regelung der Galvanisier- und Ätzanlage vorgesehen ist.

Die Umschalter und Ein/Ausschalter werden vorzugsweise mittels elektrischer Steuersignale angesteuert.

Die Amplituden der durch die elektrolytische Zelle fließenden Pulsströme werden bevorzugt bei gegebenem Verhältnis von $t_1$ (beispielsweise $t_k$: kathodischer Strompuls im ersten Zeitintervall) zu $t_2$ (beispielsweise $t_a$ im zweiten Zeitintervall) durch Einstellung des kathodischen Gleichrichterstromes $I_k$ für die kathodische Amplitude und des anodischen Gleichrichterstromes $I_a$ für die anodische Amplitude eingestellt.

Indem ferner die Amplitudenwerte der durch die elektrolytischen Zellen fließenden pulsförmigen Badströme gemessen und diese Werte mit Sollwerten verglichen werden, können die Stromamplituden in den elektrolytischen Zellen durch Verstellen des Gleichrichterstromes auch auf konstante Werte geregelt werden.

Es können zusätzlich auch weitere Zeitintervalle in die Verfahrensfolge a-b-c-d-e-f bzw. a-b-c-d eingeführt werden, beispielsweise Zeitabschnitte, in denen kein Strom durch die elektrolytischen Zellen fließt, z.B. beim Ein- und Ausfahren des Behandlungsgutes in die Elektrolytlösung. Die Umschalter werden hierzu so angesteuert, daß zwischen den Zeitintervallen $t_1$ und $t_2$ in einem Zeitintervall $t_{Null} > 0$ alle Verbindungen von den Gleichrichtern zur elektrolytischen Zelle unterbrochen werden.

Indem der Um- bzw. Ein/Ausschalter in spezieller Weise angesteuert wird, können bestimmte Verfahrensfolgen realisiert werden. Außerdem könnten die jeweils für die gewünschte Stromrichtung vorgesehenen Schaltpositionen eines Umschalters für eine Versorgung der elektrolytischen Zelle mit Gleichstrom durchgeschaltet gehalten werden, während über die jeweils anderen Positionen des Schalters keine Stromversorgung stattfindet, indem die Zeitintervalle $t_1$ oder $t_2$ bei zumindest einem Teil der elektrolytischen Zellen so groß eingestellt wird, daß der Badstrom als Gleichstrom wirkt. Entsprechendes gilt bei Verwendung von Ein/Ausschaltern.

Sind in einer Galvanisier- oder Ätzanlage mehrere elektrolytische Zellen enthalten, so können diese mit periodischen Strompulsfolgen im Takt beaufschlagt werden. In einer weiteren Ausführungsform können auch mehrere Gruppen von elektrolytischen Zellen in der Anlage enthalten sein, die innerhalb einer Gruppe jeweils parallel zueinander geschaltet sind. Vorzugsweise kann in einer Gruppe dieser elektrolytischen Zellen eine erste periodische Strompulsfolge und in einer anderen Gruppe von elektrolytischen Zellen eine zweite periodische Strompulsfolge mit einer Phasenverschiebung gegenüber der ersten Pulsfolge erzeugt werden. Beispielsweise können die elektrolytischen Zellen in einer Anlage zur Metallisierung von Leiterplatten, die sich auf der einen Seite der Leiterplatten befinden, und die Zellen, die sich auf der anderen Seite befinden, jeweils unterschiedliche Gruppen von Zellen bilden. Die elektrolytischen Pulsströme werden in diesem Fall den einzelnen Leiterplattenseiten mit Phasenverschiebung zugeleitet. Beispielsweise können die Vorderseiten der Leiterplatten zu einem beliebigen Zeitpunkt kathodisch und die Rückseiten gleichzeitig anodisch gepolt sein. Zu einem späteren Zeitpunkt wird die Polung dann umgedreht.

In einer weiteren Betriebsart kann bei beispielsweise getrennten Stromkreisen für die Versorgung der Vorder- und der Rückseiten von Leiterplatten auch zumindest ein Teil der elektrolytischen Zellen durch permanentes Unterbrechen der jeweiligen Verbindungen vom Gleichrichter zur elektrolytischen Zelle versorgt werden, während durch die Stromkreise anderer elektrolytischer Zellen pulsförmiger Strom geleitet wird.

Um zu vermeiden, daß die Einzelschalter beim Öffnen nicht zerstört werden, können ferner Dioden parallel zu den Einzelschaltern geschaltet und so gepolt sein, daß die beim Öffnen der Einzelschalter entstehende Energie ohne Zerstörungsgefahr für die Einzelschalter von den Kondensatoren aufgenommen wird.

Die Erfindung wird nachfolgend an Hand der Figuren 2 bis 5 näher erläutert. Es zeigen:

Figur 1:  schematische Darstellung der elektrolytischen Teilzellen in einer horizontalen Durchlaufanlage nach dem Stand der Technik;

Figur 2:  erfindungsgemäße Schaltungsanordnung;

Figur 3:  elektrisches Ersatzschaltbild der erfindungsgemäßen Schaltungsanordnung;

Figur 4:  zeitlicher Verlauf der Ströme und Spannungen bei bipolarer Pulsstromversorgung mit stromgeregeltem Galvanogleichrichter;

Figur 5:  zeitlicher Verlauf der Ströme und Spannungen bei bipolarer Pulsstromversorgung mit spannungsgeregeltem Galvanogleichrichter.

Die Erfindung wird am Beispiel einer horizontalen Durchlaufanlage zur Galvanisierung von Leiterplatten dargestellt. In entsprechender Weise kann die erfindungsgemäße Schaltungsanordnung und das Verfahren auch zum Ätzen von Leiterplatten sowie zur galvanotechnischen Behandlung von anderem Behandlungsgut eingesetzt werden. Außerdem sind die Schaltung und das Verfahren auch beim Einsatz in Vertikalanlagen, beispielsweise in Tauchanlagen oder in Anlagen anwendbar, bei denen das Behandlungsgut in vertikaler Ausrichtung in einer Durchlaufanlage behandelt wird.

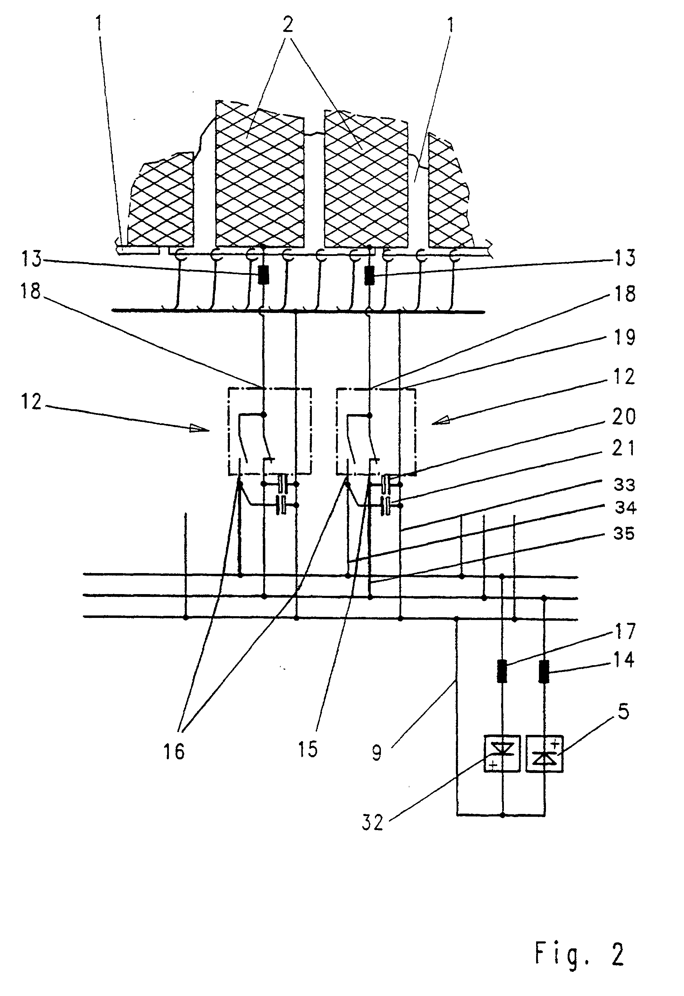

In Figur 2 ist eine erfindungsgemäße Anlage wiedergegeben. Zwei obere Anoden 2 und das Behandlungsgut 1 sind im Ausschnitt dargestellt. In den elektrischen Anschluß der Anoden 2 sind Umschalter 12 für den bipolaren Pulsbetrieb eingefügt. Die Umschalter 12 sind in der Nähe der Anoden angeordnet. Die Stromleiterführung wird so gewählt, daß die Stromleiter-Teilinduktivität 13 vom Ausgang 18 des Umschalters 12 zur elektrolytischen Zelle sehr klein ist. Dagegen können die Stromleiter-Teilinduktivitäten 14,17 von den Galvanogleichrichtern 5,32 zu den Eingängen 15,16 des Umschalters 12 beliebig groß sein.

Nachfolgend bezieht sich die Angabe der Galvanisierphase immer auf das Behandlungsgut 1. Demnach sind bei der kathodischen Galvanisierphase das Behandlungsgut negativ und die Anoden positiv gepolt. Die anodische Ätz- oder Entmetallisierungsphase wird vom Galvanogleichrichter 32 über die Stromleiter-Teilinduktivität 17 gespeist. Der zugehörige Umschaltereingang hat die Bezugsziffer 16.

In den Stromleiter-Teilinduktivitäten 14 bzw. 17 sind alle wirksamen Induktivitäten der Stromkreise von den Galvanogleichrichtern 5,32 zu den Eingängen der Umschalter 12, d.h. in den ersten Leitungen 34,35 und der zweiten Leitung 33, zusammengefaßt. In der Stromleiter-Teilinduktivität 13 sind alle wirksamen Induktivitäten des Stromkreises vom Ausgang 18 des Umschalters 12 zur elektrolytischen Zelle und zurück zum Umschalter an den Stromleiteranschluß 19 zusammengefaßt. Die Stromleiter-Teilinduktivität 13 wird durch eine räumlich sehr nahe Anordnung des Umschalters 12 zur elektrolytischen Zelle klein gehalten. Weitere bekannte Maßnahmen zur Verringerung der Leiterinduktivität sind möglich. Damit wird eine geringe Zeitkonstante Tau für den Pulsstromanstieg gemäß der Formel (L: Induktivität, R: Widerstand)

Tau = L/R

erzielt.

Die räumliche Nähe der Umschalter zur elektrolytischen Zelle ist auch bei großen Abmessungen der Galvanoanlage durch die Aufteilung in elektrolytische Teilzellen möglich. Die nahe Anordnung der Umschalter 12 zu den jeweiligen elektrolytischen Teilzellen hat zur Folge, daß die räumlich großen Galvanogleichrichter 5,32 zentral und in einem größeren Abstand von den Umschaltern 12 angeordnet werden können. Dies hat jedoch keinen Einfluß auf die Pulsanstiegsgeschwindigkeit. Gleiches gilt für die Galvanogleichrichter zur Versorgung der Unterseite des Behandlungsgutes mit pulsförmigem Strom.

Die Galvanogleichrichter 5,32 werden durch Kondensatoren 20,21 kapazitiv belastet. Für jede Pulspolarität ist ein Kondensator mit großer Kapazität vorgesehen. Der Kondensator 20 dient als Energiespeicher für den kathodischen Pulsstrom. Der Kondensator 21 speichert die Energie des anodischen Pulsstromes. In der Praxis handelt es sich bei den Kondensatoren 20,21 um mehrere parallelgeschaltete Kondensatoren mit entsprechend kleinerer Kapazität. Die kapazitiven Lasten werden mit Gleichstrom aus den Galvanogleichrichtern 5,32 über die Stromleiter und damit auch über die Stromleiter-Teilinduktivitäten 14,17 geladen.

Für den Gleichstrom ist die praktisch vorkommende Größe der Induktivität ohne Bedeutung, wenn von unbedeutenden Ein- und Ausschalteffekten abgesehen wird. Weil Galvanogleichrichter langsam ein- und ausgeschaltet werden, sind die Leiterinduktivitäten 14,17 auch hierbei ohne Einfluß auf den Galvanisier- oder Ätz- bzw. Entmetallisierprozeß. Langsames Schalten heißt, daß die Galvanogleichrichter an einer Stromrampe hochgefahren oder zurückgefahren werden.

Der Gleichstrom in den Stromleitern 33,34,35 bietet den Vorteil, daß in diesem Bereich praktisch nur magnetische Gleichfelder auftreten, die keine Gefahr für das Bedienungspersonal darstellen. Magnetische Wechselfelder treten erst am Umschalter bzw. Ein/Ausschalter und auf den kurzen Stromleitern zur elektrolytischen Zelle auf. Hohe Stromänderungsgeschwindigkeiten und kleine Galvanisier- bzw. Ätzspannungen verursachen im wesentlichen magnetische Störfelder. Wegen der Aufteilung des Galvanisierstromes in Teilströme je Anode ist auch der absolute Wert des Pulsstromes in jeder elektrolytischen Teilzelle wesentlich niedriger als der Gesamtstrom. Entsprechend niedrig sind auch die magnetischen Störfelder.

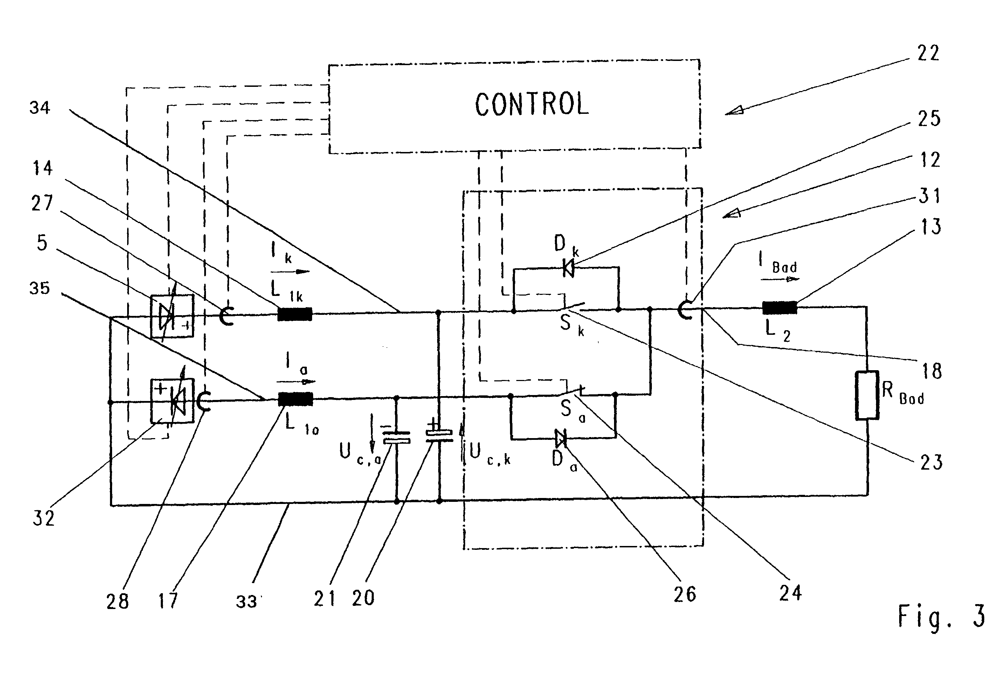

Im Ersatzschaltbild der Figur 3 sind der Umschalter 12 und die übergeordnete Steuerung 22 jeweils mit strichpunktierten Linien zusammengefaßt. Die Steuerung 22 sorgt für das zeitgerechte Schalten der Schalter 23,24 sowie für die Einstellung der Pulsamplituden durch Einwirkung auf die Gleichrichterausgangsströme entsprechend vorgegebener Sollwerte. Als Schaltelemente sind elektromechanische Kontakte symbolisch dargestellt. Praktisch werden jedoch vorzugsweise elektronische Schalter verwendet. Geeignet sind zum Beispiel MOSFET-Transistoren oder IGBTs (Isolated Gate Bipolar Transistor).

Der Schalter 23 schaltet für die Dauer des ersten Pulses die Spannung des geladenen Kondensators 20 an die elektrolytische Teilzelle, die hier als Ersatzwiderstand $R_{Bad}$ dargestellt ist. Der Schalter 24 schaltet für die Dauer der zweiten Phase die Spannung des geladenen Kondensators 21 an die elektrolytische Zeile. Die Spannungen treiben den Strom $I_{Bad}$ über die Stromleiter-Teilinduktivität 13 in den Ersatzwiderstand $R_{Bad}$. Weil die Induktivität 13 infolge der beschriebenen Maßnahmen sehr klein ist, werden die in der Leiterplattentechnik geforderten hohen Stromanstiegszeiten erreicht. Zum Beispiel für $L_2 = 2 \cdot 10^{-6}$ H und mit einem Widerstand der elektrolytischen Teilzelle von $R_{Bad} = 20 \cdot 10^{-3}$ Ohm beträgt die Zeitkonstante für den Stromanstieg auf 63 Prozent des Maximalwertes Tau $= 0,1 \cdot 10^{-3}$ Sekunden.

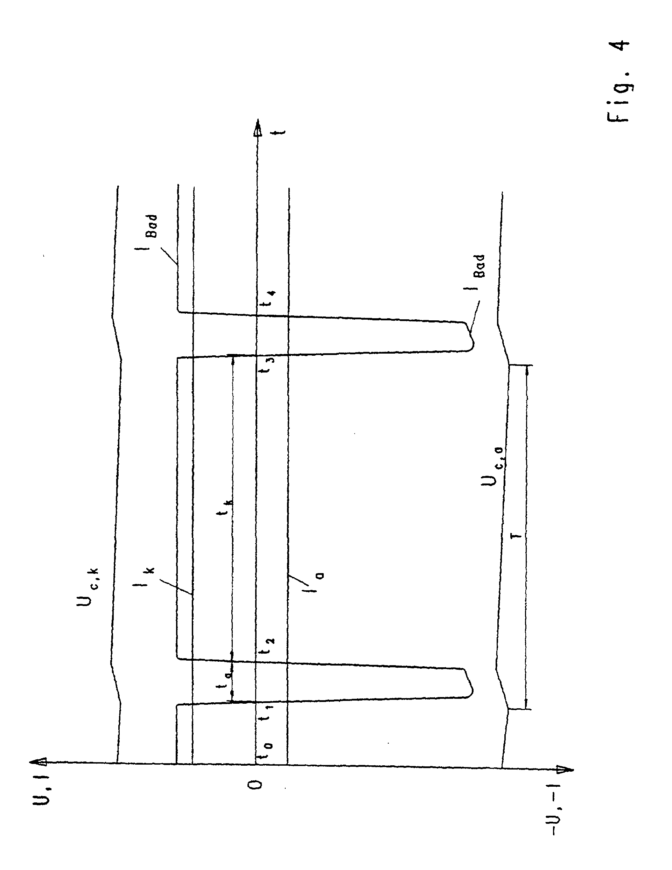

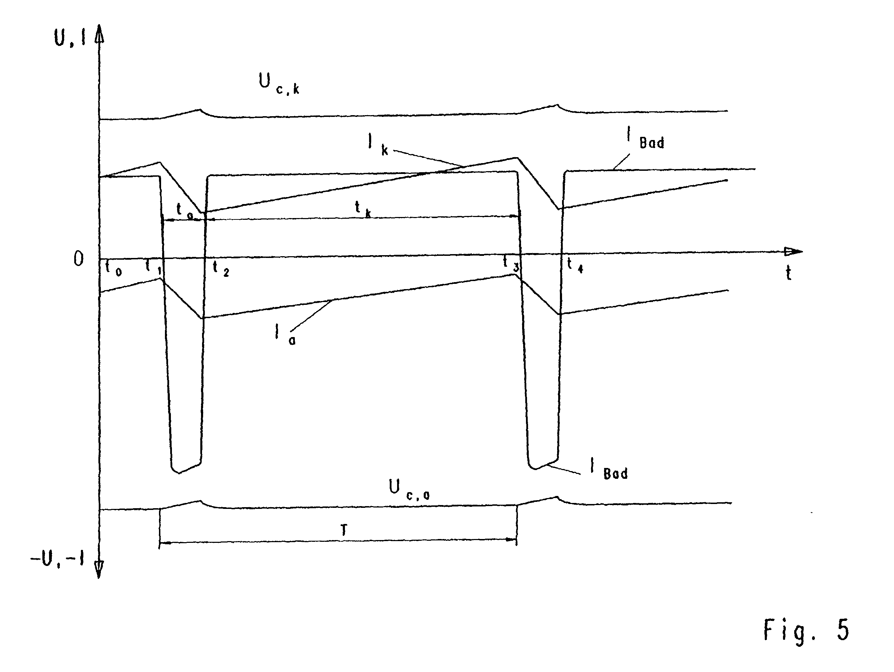

Eine übergeordnete Steuerung 22 synchronisiert die zeitlichen Abläufe. In dieser sind die Zeiten für das abwechselnde Schließen der Schalter 23,24 als Sollwerte hinterlegt, desgleichen auch die üblicherweise unterschiedlichen Pulsamplituden für die kathodische und für die anodische Pulszeit. Damit ist die erforderliche Energie zur elektrolytischen Behandlung je Polarität bekannt. Dies ist zugleich der Sollwert für den Gleichstrom des entsprechenden Galvanogleichrichters. Dieser Strom ist regelungstechnisch in den Galvanogleichrichtern als arithmetischer Strommittelwert einzustellen und konstant zu halten. Der Strom kann auf diese Weise mittels eines stromgeregelten Galvanogleichrichters direkt konstant gehalten werden. Die Ströme der Galvanogleichrichter 5,32 werden mit Stromsensoren 27,28, wie zum Beispiel Shunts, gemessen. Die zeitlichen Strom- und Spannungsverläufe von stromgeregelten Galvanogleichrichtern sind in Figur 4 dargestellt. Der arithmetische Strommittelwert kann regelungstechnisch auch durch Einstellung der Galvanogleichrichter-Ausgangsspannung konstant gehalten werden, indem sich der Strommittelwert einstellt. Die resultierenden zeitlichen Strom- und Spannungsverläufe sind in Figur 5 dargestellt.

Die Klemmenspannung der Galvanogleichrichter stellt sich so ein bzw. wird so eingestellt, daß die annähernd konstante Kondensatorspannung $U_c$ den Pulsstrom mit der erforderlichen Amplitude treibt. Es stellt sich ein Gleichgewichtszustand zwischen der vom Galvanogleichrichter abgegebenen und per Sollwert definierten Gleichstromenergie und der vom Kondensator 20,21 an den Badwiderstand $R_{Bad}$ abgegebenen pulsförmigen Energie ein. Beide Strommittelwerte sind gleich groß. Mit zunehmender Pulsamplitude steigt die Kondensatorspannung $U_c$ an. Die maximal mögliche Spannung wird von der Nennspannung des jeweiligen Galvanogleichrichters bestimmt.

In Figur 4 sind die Ströme und Spannungen einer pulsförmigen, bipolaren Badstromversorgung dargestellt. Die periodischen Pulse haben eine Zykluszeit T. Das kathodische Zeitintervall $t_k$ wechselt mit dem anodischen Zeitintervall $t_a$ ab.

Es gilt:

$$T = t_k + t_a.$$

Das Verhältnis der beiden Zeitintervalle $t_k$ zu $t_a$ wird als Tastverhältnis bezeichnet. Der Strommittelwert $I_{mittel,k}$ der kathodischen Pulse berechnet sich aus dem Tastverhältnis und den Stromscheitelwerten $\hat{I}_k$ (Stromscheitelwert des kathodischen Strompulses) und $\hat{I}_a$ (Stromscheitelwert des anodischen Strompulses) nach der Formel

$$I_{mittel,k} = (\hat{I}_k \cdot t_k) / (t_k + t_a)$$

Entsprechend berechnet sich für die anodischen Pulse der Strommittelwert $I_{mittel,a}$ aus

$$I_{mittel,a} = (\hat{I}_a \cdot t_a) / (t_a + t_k).$$

Die Strommittelwerte sind die Ausgangsgleichströme der Galvanogleichrichter. Im Zeitpunkt $t_o$ fließen die Ströme $I_k$ und $I_a$ im eingeschwungenen Zustand aus beiden Galvanogleichrichtern 5,32 (Figuren 2,3). Der Strom $I_k$ fließt über den momentan geschlossenen Schalter 23 zur Last $R_{bad}$. Zusätzlich speist der geladene Kondensator 20 Strom über die Last $R_{Bad}$. Dabei nimmt die Kondensatorspannung $U_{c,k}$ leicht ab. Der Strom des Galvanogleichrichters 32 fließt in den Kondensator 21. Dagegen steigt die Kondensatorspannung $U_{c,a}$ mit entsprechender Polarität an. Im Zeitpunkt $t_1$ öffnet der Schalter 23 und unmittelbar danach schließt der Schalter 24. Der Strom $I_k$ des Galvanogleichrichters 5 fließt weiter in voller Höhe und zwar in den Kondensator 20. Dessen Spannung $U_{c,k}$ steigt entsprechend an. Im Zeitpunkt $t_1$ fließt der Strom $I_a$ des Galvanogleichrichters 32 in voller Höhe weiter und zwar über den Schalter 24 in die Last $R_{Bad}$. Die zusätzlich erforderliche momentane Energie liefert der geladene Kondensator 21. Die Kondensatorspannung $U_{c,a}$ sinkt mit zunehmender Entladung. Im Zeitpunkt $t_2$ öffnet der Schalter 24, und unmittelbar danach wird der Schalter 23 wieder geschlossen. Anschließend wiederholt sich der Ablauf zum Zeitpunkt $t_o$ (wie oben beschrieben).

Im Zeitintervall von $t_1$ bis $t_2$ wirkt der Kondensator 21 als wesentliche Energiequelle für die elektrolytische Zelle. Entsprechend groß ist die Kapazität zu wählen, wenn die Pulsdachschräge klein gehalten werden soll. Die Kondensatoren 20,21 sollen im eingeschwungenen Zustand daher immer nur partiell geladen bzw. entladen werden.

In Figur 4 ist gezeigt, daß bei konstantem Gleichstrom der Galvanogleichrichter im wesentlichen die Spannungen auf die Pulsbelastungen reagieren. In Figur 5 ist gezeigt, daß bei nahezu konstanter Ausgangsspannung der Galvanogleichrichter im wesentlichen die Ströme auf die Pulsbelastungen reagieren. Die hierbei zu beachtende Stromwelligkeit weist keine steilen Stromflanken auf. Sie tritt auch nur zwischen dem Galvanogleichrichterausgang und dem Umschaltereingang auf. Der Pulsstrom in der elektrolytischen Zelle ist in beiden Fällen gleich. Durch die Energiezwischenspeicherung in den Kondensatoren 20,21 wird also erreicht, daß die Galvanogleichrichter einen Gleichstrom abgeben und keiner Pulsbelastung ausgesetzt sind. Pulsbedingte Störungen entfallen damit.

Im Gegensatz zur oben beschriebenen, bekannten Anordnung (Figur 1) erweist sich bei Anwendung der erfindungsgemäßen Schaltungsanordnung als weiterer Vorteil die Tatsache, daß mit einem Gleichstrom mit einer bestimmten Amplitude, das heißt mit einem bestimmten Stromscheitelwert, ein mehrfacher Pulsscheitelwert erzeugt werden kann. Der Faktor ist abhängig vom Tastverhältnis. Er liegt in der Praxis bei zehn. Das heißt, daß zum Beispiel für eine elektrolytische Teilzelle mit 50 Ampere Gleichstrom ein Pulsscheitelwert von 500 Ampere rückwärts generiert wird. In einer 3 Meter langen Versuchsdurchlaufanlage zur Galvanisierung von Leiterplatten wurde zum Beispiel mit folgenden Zeiten und Amplituden gearbeitet:

$t_a$ = 1·10$^{-3}$ Sekunden;
$t_k$ = 15·10$^{-3}$ Sekunden;
Die Stromscheitelwerte betrugen $\hat{I}_a$ = 4·$\hat{I}_k$;
Die Scheitelströme je elektrolytischer Teilzelle betrugen $\hat{I}_a$ = 800 A und $\hat{I}_k$ = 200 A;
Die Kapazität der Kondensatoren 20,21 betrug jeweils 0,5 Farad.

Im Umschalter 12 ist ein bipolar wirkender Stromsensor 31 am Schalterausgang 18 eingefügt. Der Sensor dient zur Überstromüberwachung, d.h. zum Schutz des Umschalters gegen Zerstörung. Mit diesem Stromsensor können die Scheitelwerte der Pulsströme gemessen werden. Damit können die Ströme der Galvanogleichrichter 5,32 auch direkt geregelt werden. Die Scheitelwerte werden in der übergeordneten Steuerung mit den Scheitelsollwerten verglichen. Die Stellgröße stellt den Strom der Galvanogleichrichter 5,32 so ein, daß die Pulsstrom-Scheitelwerte selbsttätig auf ihrem Sollwert konstant gehalten werden.

Beim Schalten der infolge der Stromleiter-Induktivität 13 leicht induktiven Last entstehen im Abschaltmoment Überspannungen. Diese können die elektronischen Schalter zerstören. Schutzdioden 25 und 26 mit der gezeichneten Polarität vermeiden einen zu hohen Spannungsanstieg über jedem Schalter. Die Induktionsspannungen treiben einen Strom über die Diode des Schalters, der im Abschaltmoment geöffnet war. Der Strom fließt in den Kondensator 20 beziehungsweise in den Kondensator 21. Er baut die Überspannung nutzbringend sofort ab. Die Dioden 25,26 können integrierte Dioden in den Halbleiterbauelementen darstellen.

Darüber hinaus sorgt eine elektronische Verriegelung im Umschalter 12 dafür, daß die Schalter 23,24 nicht gleichzeitig schließen können. Der zeitliche Abstand zwischen dem Öffnen des einen Einzelschalters und Schließen des anderen Schalters kann auch so vergrößert werden, daß während dieser Zeit kein galvanotechnisch wirksamer Strom fließt. Wenn es die räumlichen Gegebenheiten erlauben, können die Kondensatoren 20,21 auch mehreren parallel wirkenden Umschaltern und elektrolytischen Zellen zugeordnet werden. Gleiches gilt für die Kondensatoren 20,21 einschließlich der Schalter 23,24. Entscheidend ist, daß die räumliche Entfernung der Kondensatoren und Schalter von der elektrolytischen Zelle bzw. von den Zellen klein ist.

Für das Pulsstromgalvanisieren ist es sehr wichtig, die Amplitude und die Zeiten der Pulse einzuhalten. Nur so lassen sich die geforderten Eigenschaften der abgeschiedenen Galvanisierschichten einhalten. Problematisch ist in der Praxis, die Pulsamplitude mit einfachen Mitteln so zu messen, daß ein Regelkreis für die geforderte Stromdichte aufgebaut werden kann. Das erfindungsgemäße Verfahren ermöglicht eine überraschend einfache Bestimmung der Pulsamplituden. Der einfach zu messende und zu regelnde Konstantstrom $I_{mittel}$ der Galvanogleichrichter ist ein Maß für die Pulsenergie. Bei bekanntem Tastverhältnis läßt sich mit $I_{mittel}$ der Scheitelwert Î der Pulse nach der Formel

$$\hat{I} = I_{mittel} \, (t_{Puls} + t_{Pause}) \, / t_{Puls}$$

berechnen. Dabei sind $t_{Puls}$ das Zeitintervall, in dem ein Strompuls erzeugt wird und $t_{Pause}$ das Zeitintervall, in dem kein Strompuls erzeugt wird. Im Falle eines bipolaren Umschalters gibt $t_{Pause}$ beispielsweise für kathodische Strompulse das Zeitintervall an, in denen keine kathodischen Strompulse erzeugt werden.

In der Galvanoanlage werden die oberen Anoden 2 und die unteren Anoden 3 mit Pulsströmen gleicher Frequenz belastet. Beide Pulsfolgen können synchron ablaufen. Sie können aber auch gegeneinander phasenverschoben sein. Die bipolaren Umschalter ermöglichen bedarfsweise auch einen Galvanisier- oder Ätzgleichstrombetrieb. Bei kathodischem Betrieb, das heißt beim Galvanisieren, ist der Schalter 23 permanent geschlossen. Beim Gleichstrom-Ätzen ist der Schalter 24 permanent geschlossen. Der gegenpolige Schalter ist jeweils entsprechend permanent geöffnet.

Bezugszeichenliste:

1    Behandlungsgut Leiterplatte
2    obere Anode
3    untere Anode
4    Schaltkontakt
5    oberer Galvanogleichrichter, kathodisch
6    unterer Galvanogleichrichter, kathodisch
7    Stromleiter zu den oberen Anoden
8    Stromleiter zu den unteren Anoden
9    gemeinsamer Stromrückleiter von den Kathoden
10    Klammer
11    Schleifschiene
12    Umschalter
13    Stromleiter-Teilinduktivität vom Umschalter zur elektrolytischen Zelle
14    Stromleiter-Teilinduktivität vom Galvanogleichrichter zum Umschalter, kathodisch
15    Umschaltereingang, kathodisch
16    Umschaltereingang, anodisch

| 17 | Stromleiter-Teilinduktivität vom Galvanogleichrichter zum Umschalter, anodisch |
|---|---|
| 18 | Umschalterausgang |
| 19 | Stromleiteranschluß |
| 20 | Kondensator, kathodisch |
| 21 | Kondensator, anodisch |
| 22 | übergeordnete Steuerung |
| 23 | Schalter, kathodisch |
| 24 | Schalter, anodisch |
| 25 | Schutzdiode $D_k$ |
| 26 | Schutzdiode $D_a$ |
| 27 | Stromsensor, kathodisch |
| 28 | Stromsensor, anodisch |
| 31 | Stromsensor, bipolar |
| 32 | oberer Galvanogleichrichter, anodisch |
| 33 | erste Leitung |
| 34 | zweite Leitung, anodisch |
| 35 | zweite Leitung, kathodisch |

**Patentansprüche**

1. Schaltungsanordnung für die Versorgung einer oder mehrerer parallel geschalteter elektrolytischer Zellen mit Anoden und Kathoden in vertikalen oder horizontalen Galvanisier- oder Ätzanlagen mit pulsförmigem Strom, bei der zur Stromversorgung jeder einzelnen elektrolytischen Zelle

   a. mindestens ein Galvanogleichrichter und

   b. mindestens ein Umschalter, der von mindestens zwei Eingängen auf mindestens einen Ausgang durchschaltbar ist, oder ein Ein/Ausschalter vorgesehen sind, wobei

   c. erste Leitungen zur direkten elektrischen Verbindung jeweils eines Anschlusses der Gleichrichter mit dem einen Anschluß der elektrolytischen Zelle vorgesehen sind,

   d. zweite Leitungen zur direkten elektrischen Verbindung der jeweils anderen Ausgänge der Gleichrichter mit den Eingängen der Umschalter oder eines Anschlusses des Ein/Ausschalters vorgesehen sind und wobei ferner

   e. der jeweils mindestens eine Ausgang der Umschalter oder der andere Anschluß des Ein/Ausschalters mit dem anderen Anschluß der elektrolytischen Zelle direkt verbunden ist,

   **dadurch gekennzeichnet, daß** zwischen die erste Leitung (33) und jede zweite Leitung (34,35) mindestens ein Kondensator (20,21) geschaltet ist.

2. Schaltungsanordnung nach Anspruch 1, **dadurch gekennzeichnet, daß** sowohl die Um- und Ein/Ausschalter (12) als auch die Kondensatoren (20,21) in räumlicher Nähe zur elektrolytischen Zelle angeordnet sind, so daß die Induktivität (13) der die elektrolytische Zeile und die Um- und Ein/Ausschalter verbindenden Stromleiter minimiert wird.

3. Schaltungsanordnung nach einem der vorstehenden Ansprüche, **dadurch gekennzeichnet, daß** zwei Gleichrichter (5,32) vorgesehen sind, mit denen mehrere parallelgeschaltete elektrolytische Zellen gemeinsam mit Strom versorgt werden können, wobei jeweils mehrere Stromkreise gemeinsame Kondensatoren (20) oder (21) zur Versorgung der elektrolytischen Zellen aufweisen.

4. Schaltungsanordnung nach einem der vorstehenden Ansprüche, **dadurch gekennzeichnet, daß** zur Erzeugung einer Pulsfolge elektronische Schalter (23,24) als Um- oder Ein/Ausschalter vorgesehen sind.

5. Schaltungsanordnung nach einem der vorstehenden Ansprüche, **dadurch gekennzeichnet, daß** die Um- oder Ein/Ausschalter (23,24) jeweils mit einem Stromsensor (31) ausgestattet sind, dessen Meßsignal zur Überstromausschaltung zum Schutz der Schalter verwendbar ist.

6. Schaltungsanordnung nach Anspruch 5, **dadurch gekennzeichnet, daß** eine übergeordnete Steuerung (22) zur Überwachung und Regelung der Galvanisier- und Ätzanlage vorgesehen ist, zu der das Meßsignal jedes Stromsensors (31) übertragbar ist.

7. Schaltungsanordnung nach einem der vorstehenden Ansprüche, **dadurch gekennzeichnet, daß** die Um- und Ein/Ausschalter (23,24) so ausgebildet sind, daß sie mittels elektrischer Steuersignale ansteuerbar sind.

8. Schaltungsanordnung nach einem der vorstehenden Ansprüche, **dadurch gekennzeichnet, daß** Dioden (25,26) zu den Um- und Ein/Ausschaltern (23,24) parallel geschaltet und so gepolt sind, daß beim Öffnen der Schalter entstehende Energie ohne Zerstörungsgefahr für die Schalter von den Kondensatoren (20,21) aufgenommen wird.

9. Verfahren zur Versorgung einer oder mehrerer parallel geschalteter elektrolytischer Zellen mit Anoden und Kathoden in vertikalen oder horizontalen Galvanisier- oder Ätzanlagen mit pulsförmigem Strom mit einer Schaltungsanordnung mit

   a. mindestens zwei Galvanogleichrichtern und
   b. mindestens einem Umschalter, der von mindestens zwei Eingängen auf mindestens einen Ausgang durchschaltbar ist, wobei zur Stromversorgung jeder elektrolytischen Zelle
   c. erste Leitungen zur direkten elektrischen Verbindung jeweils eines Anschlusses der Gleichrichter mit dem einen Anschluß der elektrolytischen Zelle vorgesehen sind,
   d. zweite Leitungen zur direkten elektrischen Verbindung der jeweils anderen Ausgänge der Gleichrichter mit den Eingängen der Umschalter vorgesehen sind und wobei ferner
   e. der jeweils mindestens eine Ausgang der Umschalter mit dem anderen Anschluß der elektrolytischen Zelle direkt verbunden ist und
   f. zwischen die erste Leitung und die zweiten Leitungen jeweils mindestens ein Kondensator geschaltet ist,

   mit folgenden Verfahrensschritten:

   A. in einem Zeitintervall $t_1$:

   a. Speisen der elektrolytischen Zelle durch Verbinden eines ersten Gleichrichters mit der Zelle über eine zweite Leitung und mindestens einen Umschalter und
   b. gleichzeitiges partielles Entladen des mindestens einen Kondensators, der über eine der zweiten Leitungen mit dem ersten Gleichrichter verbunden ist;
   c. Laden der Kondensatoren, die über die anderen der zweiten Leitungen mit den anderen Gleichrichtern verbunden sind;

   B. in einem zweiten Zeitintervall $t_2$:

   d. Speisen der elektrolytischen Zelle durch Verbinden eines zweiten Gleichrichters mit der Zelle über eine zweite Leitung und mindestens einen Umschalter und
   e. gleichzeitiges partielles Entladen des mindestens einen Kondensators, der über eine andere der zweiten Leitungen mit dem zweiten Gleichrichter verbunden ist;
   f. Laden der Kondensatoren, die über die übrigen der zweiten Leitungen mit den übrigen Gleichrichtern verbunden sind.

10. Verfahren zur Versorgung einer oder mehrerer parallel geschalteter elektrolytischer Zellen mit Anoden und Kathoden in vertikalen oder horizontalen Galvanisier- oder Ätzanlagen mit pulsförmigem Strom mit einer Schaltungsanordnung mit

   a. mindestens einem Galvanogleichrichter und
   b. mindestens einem Ein/Ausschalter mit zwei Anschlüssen, wobei zur Stromversorgung jeder elektrolytischen Zelle
   c. eine erste Leitung zur direkten elektrischen Verbindung eines Anschlusses des mindestens einen Gleichrichters mit dem einen Anschluß der elektrolytischen Zelle vorgesehen ist,
   d. eine zweite Leitung zur direkten elektrischen Verbindung des anderen Ausganges des mindestens einen Gleichrichters mit dem einen Anschluß des Ein/Ausschalters vorgesehen ist, wobei ferner
   e. der andere Anschluß des Ein/Ausschalters mit dem anderen Anschluß der elektrolytischen Zelle direkt verbunden ist und
   f. bei dem ferner zwischen die erste Leitung und die zweite Leitung mindestens ein Kondensator geschaltet ist,

mit folgenden Verfahrensschritten:

    A. in einem Zeitintervall $t_1$:

        a. Speisen der elektrolytischen Zelle durch Verbinden des mindestens einen Gleichrichters mit der Zelle über die zweite Leitung und den Ein/Ausschalter und
        b. gleichzeitiges partielles Entladen des mindestens einen Kondensators;

    B. in einem Zeitintervall $t_2$:

        c. Unterbrechen der Verbindung zwischen der elektrolytischen Zelle und dem mindestens einen Gleichrichter durch den Ein/Ausschalter und
        d. Laden des mindestens einen Kondensators.

**11.** Verfahren nach einem der Ansprüche 9 und 10, **dadurch gekennzeichnet, daß** die anodischen und kathodischen Amplituden der durch die elektrolytische Zelle fließenden pulsförmigen Badströme bei gegebenem Verhältnis von $t_1$ zu $t_2$ durch Einstellung des anodischen Gleichrichterstromes $I_a$ für die anodische Amplitude und/oder des kathodischen Gleichrichterstromes $I_k$ für die kathodische Amplitude eingestellt werden.

**12.** Verfahren nach einem der Ansprüche 9 bis 11, **dadurch gekennzeichnet, daß** die Amplituden der durch die elektrolytischen Zellen fließenden pulsförmigen Badströme durch Messung der Amplitudenwerte und Vergleich dieser Werte mit Sollwerten durch Verstellung des Gleichrichterstromes auf konstante Werte geregelt werden.

**13.** Verfahren nach einem der Ansprüche 9, 11 und 12, **dadurch gekennzeichnet, daß** die Umschalter (12) so angesteuert werden, daß ein gleichzeitiges Herstellen von Verbindungen mehrerer Gleichrichter zu einer elektrolytischen Zelle mit den Umschaltern (12) nicht möglich ist.

**14.** Verfahren nach einem der Ansprüche 9 bis 13, **dadurch gekennzeichnet, daß** die Umschalter (12) so angesteuert werden, daß zwischen den Zeitintervallen $t_1$ und $t_2$ in einem Zeitintervall $t_{Null} > 0$ alle Verbindungen von den Gleichrichtern zur elektrolytischen Zelle unterbrochen werden.

**15.** Verfahren nach einem der Ansprüche 9 bis 14, **dadurch gekennzeichnet, daß** in einer Gruppe von elektrolytischen Zellen in einer Galvanisieroder Ätzanlage eine erste periodische Strompulsfolge und in einer anderen Gruppe von elektrolytischen Zellen eine zweite periodische Strompulsfolge mit einer Phasenverschiebung gegenüber der ersten Pulsfolge erzeugt wird.

**16.** Verfahren nach einem der Ansprüche 9 bis 15, **dadurch gekennzeichnet, daß** der pulsförmige Badstrom in einer elektrolytischen Zelle durch die Umschalter (12) dann unterbrochen wird, wenn in diese elektrolytische Zelle eine Leiterplatte (1) hinein- oder aus dieser herausgeführt wird.

**17.** Verfahren nach einem Ansprüche 9 bis 16, **dadurch gekennzeichnet, daß** mittels geeigneter Stromsensoren (31) an den Um- oder Ein/Ausschaltern (23,24) ermittelte Meßsignale zur Überstromausschaltung an eine übergeordnete Steuerung (22) zur Überwachung der Galvanisieroder Ätzanlage übertragen werden.

**18.** Verfahren nach einem der Ansprüche 9 bis 17, **dadurch gekennzeichnet, daß** die Zeitintervalle $t_1$ oder $t_2$ bei zumindest einem Teil der elektrolytischen Zellen so groß eingestellt wird, daß der Badstrom als Gleichstrom wirkt.

**Claims**

**1.** Circuit arrangement for supplying pulsed current to one or more parallel-connected electrolytic cells, provided with anodes and cathodes, in vertical or horizontal electroplating or etching systems, wherein, to supply current to each individual electrolytic cell, there are provided

    a. at least one electroplating rectifier and
    b. at least one changeover switch, which can be switched from at least two inputs to at least one output, or an on-off switch, wherein
    c. first lines are provided for directly electrically connecting a respective connection/terminal of the rectifiers to one connection of the electrolytic cell,

d. two lines are provided for directly electrically connecting the respective other outputs of the rectifiers to the inputs of the changeover switches or a connection of the on-off switch, and wherein also

e. at least one respective output of the changeover switches or the other connection of the on-off switch is directly connected to the other connection of the electrolytic cell,

**characterised in that** at least one capacitor (20,21) is connected between the first line (33) and every second line (34,35).

2. Circuit arrangement according to claim 1, **characterised in that** both the changeover and on-off switches (12) and the capacitors (20,21) are disposed in the spatial vicinity of the electrolytic cell, so that the inductivityl/inductance (13) of the current conductors, which connect the electrolytic cell and the changeover and on-off switches, is minimised.

3. Circuit arrangement according to one of the preceding claims, **characterised in that** two rectifiers (5,32) are provided, by means of which a plurality of parallel-connected electrolytic cells, may be jointly supplied with current, a plurality of current circuits having common capacitors (20) or (21) respectively for supplying the electrolytic cells.

4. Circuit arrangement according to one of the preceding claims, **characterised in that** electronic switches (23,24) are provided as the changeover or on-off switches to generate a pulse sequence.

5. Circuit arrangement according to one of the preceding claims, **characterised in that** the changeover or on-off switches (23,24) are respectively provided with a current sensor (31), the measuring signal of which can be used for the overload circuit-breaker to protect the switches.

6. Circuit arrangement according to claim 5, **characterised in that** a control (22), situated thereabove, is provided for monitoring and regulating the electroplating and etching system, to which the measuring signal of each current sensor (31) is transmittable.

7. Circuit arrangement according to one of the preceding claims, **characterised in that** the changeover and on-off switches (23,24) are so configured that they are actuatable by means of electrical control signals.

8. Circuit arrangement according to one of the preceding claims, **characterised in that** diodes (25,26) are connected parallel to the changeover and on-off switches (23,24) and are so poled that energy, produced during the opening of the switches, is absorbed by the capacitors (20,21) without any risk of the switches being destroyed.

9. Method of supplying pulsed current to one or more parallel-connected electrolytic cells, provided with anodes and cathodes, in vertical or horizontal electroplating or etching systems by means of a circuit arrangement having

a. at least two electroplating rectifiers and

b. at least one changeover switch, which can be switched from at least two inputs to at least one output, wherein, to supply current to each electrolytic cell,

c. first lines are provided for directly electrically connecting a respective connection of the rectifiers to one connection of the electrolytic cell,

d. two lines are provided for directly electrically connecting the other respective outputs of the rectifiers to the inputs of the changeover switches, and wherein also

e. at least one respective output of the changeover switches is directly connected to the other connection of the electrolytic cell, and

f. at least one respective capacitor is connected between the first line and the second lines,

said method having the following method steps:

A. in a time interval $t_1$:

a. energise the electrolytic cell by connecting a first rectifier to the cell via a second line and at least one changeover switch, and

b. simultaneously partially discharge at least one capacitor, which is connected to the first rectifier via one of the second lines; and

c. charge the capacitors, which are connected to the other rectifiers via the other lines of the second lines;

B. in a second time interval $t_2$:

d. energise the electrolytic cell by connecting a second rectifier to the cell via a second line and at least one changeover switch, and
e. simultaneously partially discharge at least one capacitor, which is connected to the second rectifier via another line of the second lines; and
f. charge the capacitors, which are connected to the remaining rectifiers via the remaining lines of the second lines.

10. Method of supplying pulsed current to one or more parallel-connected electrolytic cells, provided with anodes and cathodes, in vertical or horizontal electroplating or etching systems by means of a circuit arrangement having

a. at least one electroplating rectifier and
b. at least one on-off switch having two connections, wherein, to supply current to each electrolytic cell,
c. a first line is provided for directly electrically connecting a connection of at least one rectifier to one connection of the electrolytic cell,
d. a second line is provided for directly electrically connecting the other output of at least one rectifier to one connection of the on-off switch, wherein also
e. the other connection of the on-off switch is directly connected to the other connection of the electrolytic cell, and
f. wherein also at least one capacitor is connected between the first line and the second line,

said method having the following method steps:

A. in a time interval $t_1$:

a. energise the electrolytic cell by connecting at least one rectifier to the cell via the second line and the on-off switch, and
b. simultaneously partially discharge at least one capacitor;

B. in a time interval $t_2$:

c. interrupt the connection between the electrolytic cell and at least one rectifier by means of the on-off switch, and
d. charge at least one capacitor.

11. Method according to one of claims 9 and 10, **characterised in that** the anodic and cathodic amplitudes of the pulsed bath currents, flowing through the electrolytic cell, at a given ratio of $t_1$ to $t_2$ are set by setting the anodic rectifier current $I_a$ for the anodic amplitude and/or the cathodic rectifier current $I_k$ for the cathodic amplitude.

12. Method according to one of claims 9 to 11, **characterised in that** the amplitudes of the pulsed bath currents, flowing through the electrolytic cells, are regulated by measuring the amplitude values and comparing these values with desired values by adjusting the rectifier current to constant values.

13. Method according to one of claims 9, 11 and 12, **characterised in that** the changeover switches (12) are so actuated that it is not possible to produce simultaneously connections between a plurality of rectifiers and an electrolytic cell by means of the changeover switches (12).

14. Method according to one of claims 9 to 13, **characterised in that** the changeover switches (12) are so actuated that, between the time intervals $t_1$ and $t_2$, all of the connections between the rectifiers and the electrolytic cell are interrupted in a time interval $t_{zero} > 0$.

15. Method according to one of claims 9 to 14, **characterised in that** a first periodic current pulse sequence is generated in one group of electrolytic cells in an electroplating or etching system, and a second periodic current pulse sequence, having a phase shift relative to the first pulse sequence, is generated in another group of electrolytic cells.

16. Method according to one of claims 9 to 15, **characterised in that** the pulsed bath current in an electrolytic cell is interrupted by the changeover switches (12) when a printed circuit board (1) is guided into or from this electrolytic cell.

17. Method according to one of claims 9 to 16, **characterised in that** measuring signals, determined by means of suitable current sensors (31) at the changeover or on-off switches (23,24), are transmitted as the overload circuit-breaker to a control (22), disposed thereabove, for monitoring the electroplating or etching system.

18. Method according to one of claims 9 to 17, **characterised in that** the time intervals $t_1$ or $t_2$ for at least some of the electrolytic cells are set to be so long that the bath current acts as direct current.


**Revendications**

1. Dispositif de montage pour l'alimentation d'un ou de plusieurs éléments électrolytiques branchés en parallèle avec des anodes et cathodes dans des installations de galvanoplastie et de décapage verticales ou horizontales avec un courant en forme d'impulsion, avec lequel il st prévu pour l'alimentation électrique de chaque élément électrolytique individuel

   a. au moins un galvanoredresseur et
   b. au moins un inverseur qui peut être commuté d'au moins deux entrées sur au moins une sortie, ou un interrupteur à deux positions,
   c. des premières lignes étant prévues pour la liaison électrique respectivement d'un branchement des redresseurs avec un branchement de l'élément électrolytique,
   d. des deuxièmes lignes étant prévues pour l'alimentation électrique directe des autres sorties des redresseurs avec les entrées des inverseurs ou d'un branchement de l'interrupteur à deux positions et également
   e. la respectivement au moins une sortie des inverseurs ou l'autre branchement de l'interrupteur à deux positions étant directement relié à l'autre branchement de l'élément électrolytique,

   **caractérisé en ce qu'**au moins un condensateur (20, 21) est commuté entre la première ligne (33) et chaque deuxième ligne (34, 35).

2. Dispositif de montage selon la revendication 1, **caractérisé en ce qu'**aussi bien les inverseurs et interrupteurs à deux positions (12) que les condensateurs (20,21) sont disposés à proximité dans l'espace de l'élément électrolytique, de sorte que l'inductance (13) des conducteurs reliant l'élément électrolytique et les inverseurs et interrupteurs à deux positions est minimisée.

3. Dispositif de montage selon l'une quelconque des revendications précédentes, **caractérisé en ce qu'**il est prévu deux redresseurs (5, 32) avec lesquels plusieurs éléments électrolytiques branchés en parallèle peuvent être alimentés conjointement en électricité, respectivement plusieurs circuits présentant des condensateurs (20) ou (21) communs pour l'alimentation des éléments électrolytiques.

4. Dispositif de montage selon l'une quelconque des revendications précédentes, **caractérisé en ce que** des interrupteurs (23, 24) électroniques sont prévus comme inverseurs ou interrupteurs à deux positions pour la génération d'une séquence d'impulsions.

5. Dispositif de montage selon l'une quelconque des revendications précédentes, **caractérisé en ce que** les inverseurs ou interrupteurs à deux positions (23, 24) sont équipés respectivement d'un capteur de courant (31) dont le signal de mesure peut être utilisé pour le déclenchement à surintensité pour la protection des interrupteurs.

6. Dispositif de montage selon la revendication 5, **caractérisé en ce qu'**il est prévu une commande (22) prioritaire pour le contrôle et le réglage de l'installation de galvanoplastie et décapage à laquelle le signal de mesure de chaque capteur de courant (31) peut être transmis.

7. Dispositif de montage selon l'une quelconque des revendications précédentes, **caractérisé en ce que** les inverseurs et interrupteurs à deux positions (23, 24) sont conçus de telle façon qu'ils peuvent être amorcés au moyen de signaux de commande électriques.

**8.** Dispositif de montage selon l'une quelconque des revendications précédentes, **caractérisé en ce que** des diodes (25, 26) sont branchées en parallèle avec les inverseurs et interrupteurs à deux positions(23, 24) et sont polarisés de telle façon l'énergie qui se forme lors de l'ouverture des interrupteurs est réceptionnée par des condensateurs (20, 21) sans risque de destruction pour des interrupteurs.

**9.** Procédé pour l'alimentation d'un ou de plusieurs éléments électrolytiques branchés en parallèle avec des anodes et cathodes dans des installations de galvanoplastie et de décapage verticales ou horizontales avec un courant en forme d'impulsion équipé d'un dispositif de montage avec

  a. au moins deux galvanoredresseurs et
  b. au moins un inverseur, qui peut être commuté d'au moins deux entrées sur au moins une sortie, moyennant quoi pour l'alimentation électrique de chaque élément électrolytique
  c. des premières lignes sont prévues pour la liaison électrique directe de respectivement un branchement des redresseurs avec un branchement de l'élément électrolytique,
  d. des secondes lignes étant prévues pour l'alimentation électrique directe des autres sorties respectives des redresseurs avec les entrées des inverseurs et
  e. la respectivement au moins une sortie des inverseurs étant reliée directement à l'autre branchement de l'élément électrolytique et
  f. à chaque fois au moins un condensateur étant toujours branché entre la première ligne et les secondes lignes,

  avec les étapes de procédé suivantes :

  A. dans un intervalle de temps $t_1$ :

   a. alimentation de l'élément électrolytique par connexion d'un premier redresseur avec l'élément par une deuxième ligne et au moins un inverseur et
   b. déchargement partiel simultané du au moins un condensateur, qui est relié au premier redresseur par au moins une des secondes lignes ;
   c. chargement des condensateurs qui sont reliés aux autres redresseurs par les secondes autres lignes ;

  B. dans un deuxième intervalle de temps $t_2$:

   d. alimentation de l'élément électrolytique par connexion d'un deuxième redresseur avec l'élément par une deuxième ligne et au moins un inverseur et
   e. déchargement partiel simultané du au moins un condensateur, qui est relié au deuxième redresseur par une autre des secondes lignes ;
   f. chargement des condensateurs qui sont reliés aux autres redresseurs par les secondes lignes restantes.

**10.** Procédé pour l'alimentation d'un ou de plusieurs éléments électrolytiques branchés en parallèle avec des anodes et cathodes dans des installations de galvanoplastie et de décapage verticales ou horizontales avec un courant en forme d'impulsion équipé d'un dispositif de montage avec

  a. au moins un galvanoredresseur et
  b. au moins un interrupteur à deux positions avec deux branchements, moyennant quoi pour l'alimentation électrique de chaque élément électrolytique
  c. une première ligne est prévue pour la liaison électrique directe d'un branchement du au moins un redresseur avec un branchement de l'élément électrolytique,
  d. une seconde ligne est prévue pour l'alimentation électrique directe de l'autre sortie du au moins un redresseur avec un branchement de l'interrupteur à deux positions,
  e. l'autre branchement de l'interrupteur à deux positions étant relié directement à l'autre branchement de l'élément électrolytique et
  f. pour lequel au moins un condensateur est également branché entre la première ligne et la seconde ligne,

  avec les étapes de procédé suivantes :

  A. à un intervalle de temps $t_1$ :

a. alimentation de l'élément électrolytique par connexion du au moins un redresseur avec l'élément par la deuxième ligne et l'interrupteur à deux positions et

b. déchargement partiel simultané du au moins un condensateur ;

B. à un intervalle de temps $t_2$ :

c. interruption de la liaison entre l'élément électrolytique et le au moins un redresseur par l'interrupteur à deux positions et

d. chargement du au moins un condensateur.

11. Procédé selon l'une des revendications 9 et 10, **caractérisé en ce que** les amplitudes anodiques et cathodiques des courants pour bains en forme d'impulsions circulant dans l'élément électrolytique sont réglées pour un rapport $t_1/t_2$ donné par le réglage du courant de redresseur anodique $I_a$ pour l'amplitude anodique et/ou du courant de redresseur cathodique $I_k$ pour l'amplitude cathodique.

12. Procédé selon l'une quelconque des revendications 9 à 11, **caractérisé en ce que** les amplitudes des courants pour bains en forme d'impulsions circulant dans les éléments électrolytiques sont réglées par la mesure des valeurs d'amplitude et la comparaison de ces valeurs avec des valeurs prévues par réglage du courant de redresseur sur des valeurs constantes.

13. Procédé selon l'une quelconque des revendications 9 à 12, **caractérisé en ce que** les inverseurs (12) sont amorcés de telle façon qu'il est impossible d'établir simultanément des liaisons entre plusieurs redresseurs et un élément électrolytique avec les inverseurs (12).

14. Procédé selon l'une quelconque des revendications 9 à 13, **caractérisé en ce que** les inverseurs (12) sont amorcés de telle façon que toutes les liaisons entre les redresseurs et l'élément électrolytique sont interrompues entre les intervalles de temps $t_1$ et $t_2$ à un intervalle $t_{zéro} > 0$.

15. Procédé selon l'une quelconque des revendications 9 à 14, **caractérisé en ce qu'**une première séquence périodique d'impulsions de courant et une deuxième séquence périodique d'impulsions de courant sont générées respectivement dans un groupe d'éléments électrolytiques dans une installation de galvanoplastie ou de décapage et dans un autre groupe d'éléments électrolytiques avec un déphasage par rapport à la première séquence d'impulsions.

16. Procédé selon l'une quelconque des revendications 9 à 15, **caractérisé en ce que** le courant pour bain en forme d'impulsions est interrompu par les inverseurs (12) dans les cas une carte de circuits imprimés (1) est introduite dans cet élément électrolytique ou en est sortie.

17. Procédé selon l'une quelconque des revendications 9 à 16, **caractérisé en ce que** des signaux de mesure pour le déclenchement à surintensité, déterminés au moyen de capteurs de courant (31) appropriées sur les inverseurs ou interrupteurs à deux positions (23, 24), sont transmis à une commande (22) prioritaire pour le contrôle de l'installation de galvanisation ou de décapage.

18. Procédé selon l'une quelconque des revendications 9 à 17, **caractérisé en ce que** les intervalles de temps $t_1$ ou $t_2$ sont réglés au moins pour une partie des éléments électrolytiques à un niveau tel que le courant pour bain agit comme courant continu.

Fig. 1

Fig. 2

Fig. 3

CONTROL

$D_k$

$S_k$

$I_k$

$L_{1k}$

$I_a$

$L_{1a}$

$U_{c,a}$   $U_{c,k}$

$S_a$

$D_a$

$I_{Bad}$

$L_2$

$R_{Bad}$

EP 0 966 557 B1

Fig. 4

Fig. 5

EP 0 966 557 B1